(19) Europäisches Patentamt
European Patent Office
Office européen des brevets

(11) EP 2 662 675 A1

(12) EUROPÄISCHE PATENTANMELDUNG

(43) Veröffentlichungstag:
13.11.2013 Patentblatt 2013/46

(51) Int Cl.:
*G01L 1/18* (2006.01)    *G01R 33/09* (2006.01)

(21) Anmeldenummer: 12167042.6

(22) Anmeldetag: 07.05.2012

(84) Benannte Vertragsstaaten:
AL AT BE BG CH CY CZ DE DK EE ES FI FR GB
GR HR HU IE IS IT LI LT LU LV MC MK MT NL NO
PL PT RO RS SE SI SK SM TR
Benannte Erstreckungsstaaten:
BA ME

(71) Anmelder: Melexis Technologies NV
3980 Tessenderlo (BE)

(72) Erfinder:
• Huber, Samuel
  6403 Küssnacht am Rigi (CH)

• Raman, Johan
  9910 Knesselare (BE)
• Rombouts, Pieter
  9030 Mariakerke (BE)
• Van Der Wiel, Appolonius Jacobus
  3080 Duisburg (BE)

(74) Vertreter: Hertoghe, Kris Angèle Louisa et al
DenK iP bvba
Hundelgemsesteenweg 1114
9820 Merelbeke (BE)

(54) **Verfahren für die Bestimmung eines Stresswertes für isotropen Stress und Verfahren für die Bestimmung eines Magnetfeldes und Stresssensor und Hallsensor**

(57) Die Erfindung betrifft ein Verfahren für die Bestimmung eines Stresswertes $V_s$ für isotropen Stress, mittels eines Hallelementes (1), das ein plattenförmiges Gebiet aus einem dotierten Halbleitermaterial aufweist und vier Kontakte (9) umfasst, die das Gebiet kontaktieren und winkelmässig gleichmässig um jeweils 90° versetzt sind. Das Verfahren umfasst

Messen mindestens eines Van der Pauw Wertes in mindestens einem Van der Pauw Mess-Setup des Hallelementes (1),

aus dem mindestens einen Van der Pauw Wert Berechnen einer Schichtwiderstandsgrösse, und

Berechnen des Stresswertes $V_s$, der wenigstens von der Schichtwiderstandgrösse abhängt. Die Erfindung betrifft weiter ein Verfahren für die Bestimmung einer Komponente eines Magnetfeldes, bei dem das Ausgangssignal des Hallelementes (1) stress- und, fakultativ, temperaturkompensiert wird, sowie einen Stresssensor und einen stress- und temperaturkompensierten Hallsensor.

Fig. 1

EP 2 662 675 A1

**Beschreibung**

Die Erfindung betrifft ein Verfahren für die Bestimmung eines Stresswertes für isotropen Stress und ein Verfahren für die Bestimmung einer Komponente eines Magnetfeldes, sowie einen Stresssensor und einen stress- und temperaturkompensierten Hallsensor.

Hallelemente sind Magnetfeldsensoren, die auf dem Hall-Effekt basieren und ein elektrisches Ausgangssignal liefern, das proportional zu einer vorbestimmten Komponente des Magnetfeldes ist. Ein Hallsensor umfasst ein Hallelement oder ein Cluster von Hallelementen und eine elektronische Schaltung für den Betrieb des/der Hallelemente und die Auswertung der Ausgangssignale der Hallelemente. Der Hallsensor wird als integrierte Schaltungen hergestellt, die in einen Halbleiterchip eingebettet ist. Der Halbleiterchip ist in ein Gehäuse verpackt. Hallelemente weisen einen Offset auf, der von prozess- und geometriebedingten Abweichungen herrührt. Der Offset kann durch die Parallelschaltung von mehreren Hallelementen (Cluster) und/oder den Betrieb mit der bekannten Spinning Current Methode wirksam verringert werden. Dies ist bekannt aus einer Vielzahl von Patentdokumenten, z.B. WO 0118556, EP 548391, DE 4302342.

Der im Gehäuse verpackte Halbleiterchip ist mechanischen Spannungen ausgesetzt, die von Umwelteinflüssen wie Temperatur und Feuchtigkeit, etc. abhängen. Die wechselnden mechanischen Spannungen bewirken einerseits Veränderungen des Offsets der Hallelemente und wegen des Piezo-Hall-Effekts auch Veränderungen der Empfindlichkeit der Hallelemente. Veränderungen des Offsets werden durch die oben beschriebenen Massnahmen wirksam unterdrückt. Um die Änderungen der Empfindlichkeit zu kompensieren, ist es bekannt, beispielsweise aus DE 10154495, DE 10154498, DE 102004003853, DE 102008051949, einen Stresssensor einzusetzen, der die mechanischen Spannungen erfasst, und dessen Ausgangssignal zu verwenden, um die durch den Piezo-Hall-Effekt bewirkte Änderung der Empfindlichkeit der Hallelemente zu kompensieren.

Der Erfindung liegen die Aufgaben zugrunde, in einem Halbleiterchip den isotropen Stress zu messen und die durch den isotropen Stress und den Piezo-Hall-Effekt bewirkten Änderungen der Empfindlichkeit eines Hallelementes zu kompensieren und schliesslich einen weitgehend stresskompensierten Hallsensor zu entwickeln.

Die Resultate der Erfindung sind ein Verfahren für die Messung des isotropen Stresses mit den Merkmalen des Anspruchs 1, ein erstes Verfahren für die Bestimmung einer Komponente eines Magnetfeldes mit den Merkmalen des Anspruchs 6 und ein zweites solches Verfahren mit den Merkmalen des Anspruchs 7, ein Stresssensor mit den Merkmalen des Anspruchs 11 und ein stress- und temperaturkompensierter Hallsensor mit den Merkmalen des Anspruchs 12. Vorteilhafte Ausgestaltungen ergeben sich aus den abhängigen Ansprüchen.

Die Erfindung wird nachfolgend anhand von Ausführungsbeispielen und anhand der Zeichnung näher erläutert.

Fig. 1         zeigt eine bevorzugte Ausführung eines in einem Halbleiterchip integrierten Hallsensors mit einem Hallelement,

Fig. 2A bis F    zeigen verschiedene Schaltschema für die Messung von Hallspannungen, van der Pauw Spannungen und Innenwiderständen des Hallelementes, und

Fig. 3         zeigt die Orientierung des Hallelementes in Bezug auf die Kanten des Halbleiterchips.

Ein erfindungsgemässer Stresssensor umfasst ein Messelement, eine elektronische Schaltung mit den Komponenten, die für die Durchführung von Messungen am Messelement erforderlich sind, einen Temperatursensor und einen Microkontroller. Der Stresssensor kann beispielsweise als Drucksensor eingesetzt werden. Ein erfindungsgemässer Hallsensor umfasst in gleicher Weise ein Hallelement, eine elektronische Schaltung mit den Komponenten, die für die Durchführung von Messungen am Hallelement erforderlich sind, einen Temperatursensor und einen Microkontroller. Das Hallelement ist ein sogenanntes horizontales Hallelement und umfasst vier Kontakte, die winkelmässig gleichmässig um jeweils 90° versetzt sind. Das Hallelement dient einerseits zur Messung des isotropen Stresses und andererseits zur Messung der Komponente des Magnetfeldes, die senkrecht zu seiner aktiven Oberfläche verläuft.

Die elektronische Schaltung und der Microkontroller sind in einen Halbleiterchip integriert. Das Messelement des Stresssensors ist ein plattenförmiges Element, das die gleiche Struktur wie das horizontale Hallelement des Hallsensors hat. Das Messelement des Stresssensors ist somit ein Hallelement. Um Doppelspurigkeiten zu vermeiden, wird die Erfindung im folgenden anhand eines Hallsensors erläutert, wobei sich alles auf einen erfindungsgemässen Stresssensor übertragen lässt, bei dem das Hallelement das plattenförmige Messelement ist. Das Hallelement ist typischerweise auch im Halbleiterchip integriert, es kann aber auch ein eigenständiges, diskretes Hallelement sein.

Es gibt verschiedene Stresskomponenten, die auf das Hallelement einwirken. Ausgehend von den Bezeichnungen $\sigma_{xx}$, $\sigma_{yy}$ und $\sigma_{zz}$ für die mechanischen Normalspannungskomponenten entlang der x-, y- bzw. z-Achse und der Bezeichnung $\sigma_{xy}$ für die mechanische Scherspannungskomponente, üben insbesondere folgende Stresskomponenten einen Einfluss auf die Empfindlichkeit und/oder die Resistivität des Hallelementes aus:

$$\sigma_{iso} = \sigma_{xx} + \sigma_{yy} \quad \text{bezeichnet als isotroper Stress}$$

(fortgesetzt)

| | |
|---|---|
| $\sigma_{diff} = \sigma_{xx} - \sigma_{yy}$ | bezeichnet als differenzieller Stress |
| $\sigma_{yy}$ | bezeichnet als Scherspannung, auf englisch "shear stress" |

wobei hier vorausgesetzt wird, dass das Hallelement in der xy-Ebene liegt und die Kanten des Halbleiterchips parallel zur x-Achse bzw. y-Achse verlaufen. Im folgenden bezeichnen zudem

| | |
|---|---|
| $\pi_{11}, \pi_{12}, \pi_{44}$ | piezo-resistive Koeffizienten |
| $\Pi_{11}, \Pi_{12}, \Pi_{66}$ | durch eine Tensoroperation der Drehlage der Kanten des Halbleiterchips bezüglich der Kristallachsen des Wafers angepasste piezo-resistive Koeffizienten |
| $P_{11}, P_{12}, P_{44}$ | piezo-Hall Koeffizienten |
| $T$ | die Temperatur |
| $T_a$ | die aktuelle Temperatur des Hallelementes |
| $\rho_0(T)$ | die von der Temperatur im stresslosen Zustand abhängige Resistivität des Hallelementes |
| $d$ | eine mittlere Dicke des Hallelementes |

Davon abgeleitete Grössen sind

$$\varepsilon_I = \frac{\Pi_{11} + \Pi_{12}}{2}\sigma_{iso}$$

$$\varepsilon_D = \frac{\Pi_{11} - \Pi_{12}}{2}\sigma_{diff}$$

$$\varepsilon_T = \Pi_{66}\sigma_{xy}$$

Die Erfindung wird im folgenden im Detail erläutert anhand eines Hallsensors. Der Hallsensor ist in die aktive Oberfläche eines Halbleiterchips integriert und beispielsweise in CMOS Technologie gefertigt. Das Hallelement ist bei diesem Beispiel ebenfalls in den Halbleiterchip integriert.

I. Mess-Setup

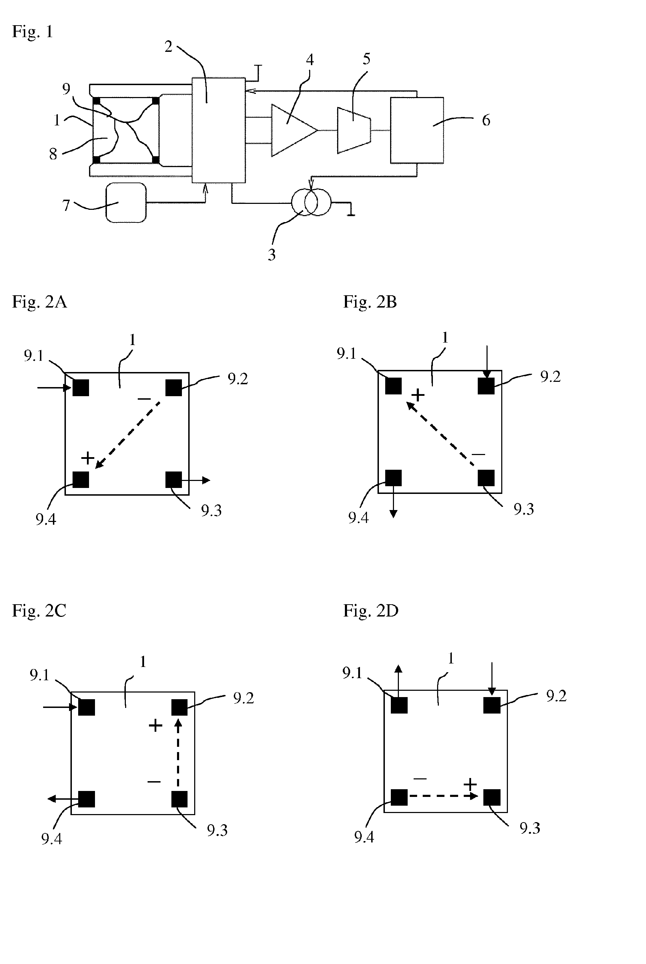

Die Fig. 1 zeigt das Blockschaltschema des Hallsensors. Der Hallsensor umfasst ein Hallelement 1, eine Schaltmatrix 2, eine Stromquelle 3, einen Differenzverstärker 4, einen Analog-Digital Wandler 5, einen Microkontroller 6 und einen Temperatursensor 7. Das Hallelement 1 ist ein sogenanntes horizontales Hallelement, das empfindlich ist auf die senkrecht zur aktiven Oberfläche des Halbleiterchips verlaufende Komponente des Magnetfeldes. Die Stromquelle 3 ist eine gesteuerte Gleichstrom-Konstantstromquelle, deren Stromstärke I vom Microkontroller 6 einstellbar ist. Sie hat einen Minuspol und einen Pluspol. Der Differenzverstärker 4 hat einen Minuseingang und einen Pluseingang. Der Microkontroller 6 steuert die einzelnen Komponenten des Hallsensors und enthält Programmiercode und Kalibrierdaten für die Berechnung der Stärke der Magnetfeldkomponente.

Das Hallelement 1 weist ein plattenförmiges Gebiet aus einem dotierten Halbleitermaterial auf und umfasst vier Kontakte 9, die das Gebiet kontaktieren und winkelmässig gleichmässig um jeweils 90° versetzt sind. Das plattenförmige Gebiet ist bei dieser integrierten Ausgestaltung eine Wanne 8 eines ersten Leitfähigkeitstyps, die in ein Gebiet eines zweiten Leitfähigkeitstyps eingebettet ist. Das Hallelement 1 ist bezüglich eines Symmetriepunktes invariant gegenüber Drehungen um 90°. Die Wanne 8 ist vorzugsweise quadratisch und die vier Kontakte 9 sind vorzugsweise in den Ecken des Quadrats angeordnet. Die Wanne 8 kann auch kreuzförmig und die Kontakte 9 an den Enden der Arme des Kreuzes angeordnet sein.

Die Schaltmatrix 2 dient dazu, jeweils zwei Kontakte 9 des Hallelementes 1 mit der Stromquelle 3 und die beiden anderen Kontakte 9 mit dem Differenzverstärker 4 zu verbinden. Dabei sind sechs verschiedene Schaltzustände vorgesehen, die in den Fig. 2A bis F dargestellt sind. Kurze Pfeile illustrieren die Stromrichtung, lange gestrichelte Pfeile zusammen mit den Symbolen + und - illustrieren die Polarität der Spannung in Bezug auf die Eingänge des Differenzverstärkers 4.

Das erfindungsgemässe Verfahren wird nun im Detail erläutert anhand einer bevorzugten Ausführung, bei der die Messungen durch Einspeisung eines Stroms, der von der Stromquelle 3 geliefert wird, und der Messung von Spannungen mittels des Differenzverstärkers 4 durchgeführt werden. Damit die verschiedenen gemessenen Spannungen wie in den weiter unten folgenden Gleichungen beschrieben miteinander verknüpft werden können, müssen sich die Spannungen auf den gleichen Strom I beziehen. D.h. die Stromquelle 3 liefert entweder für alle Messungen der verschiedenen Spannungen in den Schaltzuständen 1 bis 6 den gleichen Strom I oder die gemessenen Spannungen werden so skaliert, dass sie sich auf einen gleichen Strom I beziehen.

Schaltzustand 1 = Diagonal Mess-Setup 1 (Fig. 2A)

Die einander diametral gegenüberliegenden Kontakte 9.1 und 9.3 sind mit der Stromquelle 3 verbunden, die einander diametral gegenüberliegenden Kontakte 9.2 und 9.4 sind mit dem Differenzverstärker 4 verbunden. Der Strom fliesst vom Pluspol der Stromquelle 3 zum Kontakt 9.1 und vom Kontakt 9.3 zum Minuspol der Stromquelle 3, wie dies durch Pfeile angedeutet ist. Der Kontakt 9.2 ist mit dem Minuseingang des Differenzverstärkers 4, der Kontakt 9.4 mit dem Pluseingang des Differenzverstärkers 4 verbunden. Die in diesem Zustand am Differenzverstärker 4 anliegende Spannung wird als Diagonalspannung $V_{diag1}$ bezeichnet.

Schaltzustand 2 = Diagonal Mess-Setup 2 (Fig. 2B)

Die einander diametral gegenüberliegenden Kontakte 9.2 und 9.4 sind mit der Stromquelle 3 verbunden, die einander diametral gegenüberliegenden Kontakte 9.3 und 9.1 sind mit dem Differenzverstärker 4 verbunden. Der Strom fliesst vom Pluspol der Stromquelle 3 zum Kontakt 9.2 und vom Kontakt 9.4 zum Minuspol der Stromquelle 3. Der Kontakt 9.3 ist mit dem Minuseingang des Differenzverstärkers 4, der Kontakt 9.1 mit dem Pluseingang des Differenzverstärkers 4 verbunden. Die in diesem Zustand am Differenzverstärker 4 anliegende Spannung wird als Diagonalspannung $V_{diag2}$ bezeichnet.

Die beiden Schaltzustände 1 und 2 sind die beim Betrieb eines Hallelementes mit der Spinning Current Methode wohlbekannten Orthogonalpositionen, d.h. sie unterscheiden sich durch eine Drehung des Hallelementes um 90°. Die erste Diagonalspannung $V_{diag1}$ und die zweite Diagonalspannung $V_{diag2}$ werden üblicherweise als Hallspannung $V_{Hall1}$ bzw. als Hallspannung $V_{Hall2}$ bezeichnet.

Schaltzustand 3 = Van der Pauw Mess-Setup 1 (Fig. 2C)

Die benachbarten Kontakte 9.1 und 9.4 sind mit der Stromquelle 3 verbunden, die benachbarten Kontakte 9.2 und 9.3 sind mit dem Differenzverstärker 4 verbunden. Der Strom fliesst vom Pluspol der Stromquelle 3 zum Kontakt 9.1 und vom Kontakt 9.4 zum Minuspol der Stromquelle 3. Der Kontakt 9.2 ist mit dem Minuseingang des Differenzverstärkers 4, der Kontakt 9.3 mit dem Pluseingang des Differenzverstärkers 4 verbunden. Die in diesem Zustand am Differenzverstärker 4 anliegende Spannung wird als van der Pauw Spannung $V_{vdP1}$ bezeichnet.

Schaltzustand 4 = van der Pauw Mess-Setup 2 (Fig. 2D)

Die benachbarten Kontakte 9.1 und 9.2 sind mit der Stromquelle 3 verbunden, die benachbarten Kontakte 9.4 und 9.3 sind mit dem Differenzverstärker 4 verbunden. Der Strom fliesst vom Pluspol der Stromquelle 3 zum Kontakt 9.2 und vom Kontakt 9.1 zum Minuspol der Stromquelle 3. Der Kontakt 9.3 ist mit dem Minuseingang des Differenzverstärkers 4, der Kontakt 9.4 mit dem Pluseingang des Differenzverstärkers 4 verbunden. Die in diesem Zustand am Differenzverstärker 4 anliegende Spannung wird als van der Pauw Spannung $V_{vdP2}$ bezeichnet.

Der Schaltzustand 3 und der Schaltzustand 4 unterscheiden sich durch eine Drehung des Hallelementes um 90°, d.h. sie sind auch zueinander orthogonal.

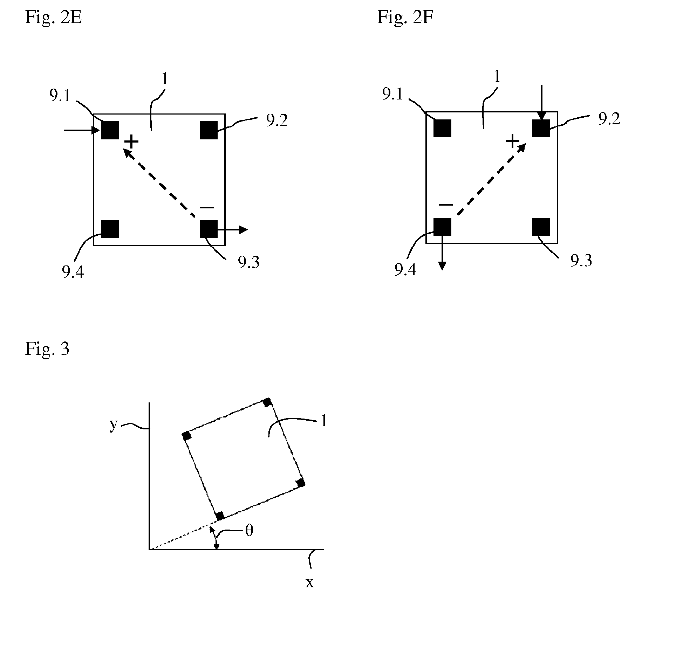

Schaltzustand 5 = Widerstands-Mess Setup 1 (Fig. 2E)

Die einander diametral gegenüberliegenden Kontakte 9.1 und 9.3 sind mit der Stromquelle 3 und dem dem Differenzverstärker 4 verbunden. Der Strom fliesst vom Pluspol der Stromquelle 3 zum Kontakt 9.1 und vom Kontakt 9.3 zum Minuspol der Stromquelle 3. Der Kontakt 9.1 ist mit dem Pluseingang des Differenzverstärkers 4, der Kontakt 9.3 mit dem Minuseingang des Differenzverstärkers 4 verbunden. Die in diesem Zustand am Differenzverstärker 4 anliegende Spannung wird als Spannungsabfall $V_{W1}$ bezeichnet.

Schaltzustand 6 = Widerstands-Mess Setup 2 (Fig. 2 F)

Die einander diametral gegenüberliegenden Kontakte 9.2 und 9.4 sind mit der Stromquelle 3 und dem dem Differenzverstärker 4 verbunden. Der Strom fliesst vom Pluspol der Stromquelle 3 zum Kontakt 9.2 und vom Kontakt 9.4 zum Minuspol der Stromquelle 3. Der Kontakt 9.2 ist mit dem Pluseingang des Differenzverstärkers 4, der Kontakt 9.4 mit dem Minuseingang des Differenzverstärkers 4 verbunden. Die in diesem Zustand am Differenzverstärker 4 anliegende Spannung wird als Spannungsabfall $V_{W2}$ bezeichnet.

Der Schaltzustand 5 und der Schaltzustand 6 unterscheiden sich durch eine Drehung des Hallelementes um 90°, d.h. sie sind auch zueinander orthogonal.

Das erfindungsgemässe Verfahren kann auch dahingehend abgeändert werden, dass in den Schaltzuständen 1 bis 6 die Stromquelle 3 durch eine Spannungsquelle ersetzt wird. In diesem Fall wird z. B. in Serie zur Spannungsquelle ein Strommessgerät angeordnet, das den von der Spannungsquelle gelieferten Strom misst. Aus dem Verhältnis der jeweils am Differenzverstärker 4 anliegenden Spannung und dem mit Hilfe des Strommessgeräts gemessenen Stroms wird ein Widerstand berechnet. Der Widerstand kann mit einem vorbestimmten Strom I multipliziert werden, um so für alle Messungen eine normierte Spannung zu erhalten, die sich auf den gleichen Strom I bezieht und die für die nachfolgend beschriebenen Berechnungen verwendet werden kann.

Die vom Differenzverstärker 4 gemessenen Spannungen werden mittels des Analog-Digital Wandlers 5 digitalisiert und können dann im Microkontroller 6 für die Berechnung eines Stresswertes für den isotropen Stress des Stresssensors und gegebenenfalls für die Berechnung eines stress - und temperaturkompensierten Ausgangssignals des Hallsensors verwendet werden. Dazu werden folgende Grössen eingeführt, eine Offsetspannung $V_{Offset}$

$$V_{Offset} = \tfrac{1}{2} * (V_{diag1} - V_{diag2}) \qquad (1)$$

und eine differenzielle Widerstandsspannung

$$\Delta V_w = V_{w1} - V_{w2} \qquad (2)$$

Die beiden van der Pauw Spannungen und die Offsetspannung stehen durch folgende Gleichung in Beziehung miteinander:

$$V_{Offset} = V_{vdP2} - V_{vdP1} \qquad (3)$$

Da die Offsetspannung und die van der Pauw Spannungen gemäss Gleichung (3) miteinander verknüpft sind, ist es äquivalent die beiden Diagonalspannungen $V_{diag1}$ und $V_{diag2}$ zu messen und entweder

a) die beiden van der Pauw Spannungen $V_{vdP1}$ und $V_{vdP2}$ zu messen, wobei die Offsetspannung $V_{Offset}$ entweder mittels der Gleichung (1) oder der Gleichung (3) berechnet werden kann, oder
b) nur eine van der Pauw Spannung $V_{vdP1}$ zu messen und die zweite van der Pauw Spannung $V_{vdP2}$ unter Berücksichtigung der beiden Diagonalspannungen $V_{diag1}$ und $V_{diag2}$ mittels der Gleichungen (1) und (3) zu berechnen zu

$$V_{vdP2} = V_{vdP1} + V_{Offset} = V_{vdP1} + \tfrac{1}{2} * (V_{diag1} - V_{diag2}) \qquad (4)$$

Die Diagonalspannungen $V_{diag1}$ und $V_{diag2}$, die Offsetspannung $V_{Offset}$, die beiden van der Pauw Spannungen $V_{vdP1}$ und $V_{vdP2}$ und die differenzielle Widerstandspannung $\Delta V_w$ ändern sich unter dem Einfluss mechanischer Belastungen des Halbleiterchips. Im allgemeinen Fall werden sowohl die van der Pauw Spannungen $V_{vdP1}$ und $V_{vdP2}$ als auch die differenzielle Widerstandspannung $\Delta V_w$ für die Kompensation des Einflusses des Stresses auf die Hall-Ausgangsspannung $V_{Hall}$ benutzt. Im konkreten Einzelfall mag es jedoch genügen, nur die van der Pauw Spannungen $V_{vdP1}$ und $V_{vdP2}$ oder sogar eine einzige van der Pauw Spannung $V_{vdP1}$ oder $V_{vdP2}$ für die Kompensation zu benutzen. Dies hängt davon ab, welche Stresskomponenten im konkreten Einzelfall auf das Hallelement 1 einwirken.

Wenn das Hallelement 1 in einer Umgebung, wo kein Magnetfeld herrscht, als plattenförmiges Messelement für die Erfassung des isotropen Stresses eingesetzt wird, dann gilt

$$V_{diag1} = -V_{diag2} \tag{5}$$

weshalb es in diesem Fall genügt, nur eine der Diagonalspannungen zu messen.

Da die Widerstandsspannungen $V_{w1}$ und $V_{w2}$ relativ grosse Werte haben, ist es vorteilhaft, zwischen der Schaltmatrix 2 und dem Differenzverstärker 4 eine zusätzliche Schaltung anzuordnen, die die Differenz der beiden Widerstandsspannungen $V_{w1}$ und $V_{w2}$ auf analoge Weise bildet, so dass dem Differenzverstärker 4 die differenzielle Widerstandsspannung $\Delta V_w$ zur Verstärkung zugeführt wird. Eine solche zusätzliche Schaltung Schaltung kann beispielsweise mit der "switched capacitor" Technik realisiert werden.

II. Bildung des Stresswertes für den isotropen Stress

Die Bildung des Stresswertes umfasst die Berechnung einer Schichtwiderstandsgrösse unter Berücksichtigung wenigstens eines der beiden van der Pauw Messwerte und die Berechnung des Stresswertes unter Berücksichtigung der Schichtwiderstandsgrösse. Die Schichtwiderstandsgrösse ist typischerweise als Schichtwiderstandswert $R_{sq}$ oder bevorzugt als Schichtwiderstandsspannung $V_{sq}$ darstellbar. Die Schichtwiderstandsspannung $V_{sq}$ und der Schichtwiderstand $R_{sq}$ sind miteinander verknüpft gemäss

$$V_{sq} = R_{sq} * I \tag{6}$$

wobei die Grösse I den Strom bezeichnet, der für die Messung der van der Pauw Spannung eingesetzt wurde.

Die Bildung des Stresswertes kann auf der Basis von Widerständen wie auch auf der Basis von Spannungen erfolgen. Da ein Widerstandswert durch Multiplikation mit einem bestimmten Strom in einen Spannungswert umgewandelt werden kann, wird die Bildung des Stresswertes im Folgenden anhand von Spannungen erläutert. Die Schichtwiderstandsgrösse ist dann die Schichtwiderstandsspannung $V_{sq}$.

A) Berechnung der Schichtwiderstandsspannung des Hallelementes 1

Die Schichtwiderstandsspannung $V_{sq}$ kann aus den beiden van der Pauw Spannungen durch Lösen der Gleichung

$$\exp\left(-\pi \frac{V_{vdP1}}{V_{sq}}\right) + \exp\left(-\pi \frac{V_{vdP2}}{V_{sq}}\right) = 1 \tag{7}$$

berechnet werden.

Die Gleichung (7) lässt sich mit der Definition

$$V_{vdP} = \frac{V_{vdP1} + V_{vdP2}}{2} \tag{8}$$

und mit Gleichung (3) darstellen als

$$V_{sq} = \frac{\pi}{\ln 2 + \ln \cosh\left(\frac{\pi}{2} \frac{V_{Offset}}{V_{sq}}\right)} V_{vdP} \tag{9}$$

Die Gleichung (9) kann beispielsweise iterativ gelöst werden. Die iterative Lösung konvergiert, ausgehend von $V_{sq} = \infty$ wegen $V_{Offset} \ll V_{vdP}$ und $V_{Offset} \ll V_{sq}$ mit nur ein oder zwei Iterationen. Mit einem Iterationsschritt erhält man

$$V_{sq} = \frac{\pi}{\ln 2} V_{vdP} \qquad (10)$$

Mit zwei Iterationsschritten erhält man

$$V_{sq} = \frac{\pi}{\ln 2 + \ln\cosh\left(\dfrac{\ln 2}{2}\dfrac{V_{Offset}}{V_{vdP}}\right)} V_{vdP} \qquad (11)$$

Die rechte Seite dieser Gleichung kann als Reihe dargestellt und mit Einbezug von Termen bis zur zweiten Ordnung von $V_{Offset}$ angenähert berechnet werden zu

$$V_{sq} = \frac{\pi}{\ln 2}\left(V_{vdP} - \frac{\ln 2}{8}\frac{V_{Offset}^2}{V_{vdP}}\right) \qquad (12)$$

Die van der Pauw Spannungsmessungen dienen somit dazu, die stressabhängige Widerstandsänderung des Schichtwiderstands $R_{sq}$ der Wanne 8 des Hallelementes 1 zu erfassen. Die Schichtwiderstandsspannung $V_{sq}$ hängt hauptsächlich vom isotropen Stress $\sigma_{iso}$ ab, während der Einfluss des differenziellen Stresses $\sigma_{diff}$ und des Shear Stresses $\sigma_{xy}$ Effekte zweiter Ordnung sind.

Wenn der Offset $V_{Offset}$ verschwindet oder vernachlässigbar klein ist, dann gilt in guter Näherung

$$V_{vdP1} \cong V_{vdP2} \qquad (13)$$

In diesem Fall lässt sich die Gleichung (7) lösen und ergibt folgende äquivalente Beziehungen

$$V_{sq} = \frac{\pi}{\ln 2} V_{vdP1} = \frac{\pi}{\ln 2} V_{vdP2} = \frac{\pi}{2\ln 2}\left(V_{vdP1} + V_{vdP2}\right) \qquad (14)$$

B) Bestimmung des Stresswertes

Der Stresswert wird bevorzugt als Stressspannung $V_s$ dargestellt. Die Stressspannung $V_s$ soll eine Grösse sein, die vom isotropen Stress $\sigma_{iso}$ abhängt, vom differenziellen Stress $\sigma_{diff}$ und dem Shear Stress $\sigma_{xy}$ jedoch wenig beeinflusst wird. Die Stressspannung $V_s$ ist eine nicht-lineare Funktion $F(V_{sq}, V_{Offset}, \Delta V_w)$ der mit dem Mess-Setup gemessenen und berechneten Grössen $V_{sq}$, $V_{Offset}$ und $\Delta V_w$.

Die Funktion F kann beispielsweise mittels Finiter Elemente Simulationen unter verschiedenen Stressbedingungen ermittelt werden. Für jede Stressbedingung werden die Werte $V_{sq}$, $V_{Offset}$ und $\Delta V_w$ für einen vorgegebenen Strom I berechnet. Die Funktion $F(V_{sq}, V_{Offset}, \Delta V_w)$ wird dann bestimmt, indem beispielsweise nach der Methode der kleinsten Quadrate (d.h. mittels eines "least squares Fits") die Abweichungen

$$F\left(V_{sq}, V_{Offset}, \Delta V_w\right) - \frac{\rho_0(T)}{d} I\left(1 + \varepsilon_I\right) \qquad (15)$$

minimiert werden.

Unter der Annahme, dass die Kontakte 9 kleine Kontakte sind, die am Rand der Wanne 8 des Hallelementes 1 angeordnet sind, gelten in guter Näherung folgende Gleichungen

$$V_{sq} \approx \frac{\rho_0(T)}{d} I \sqrt{\left(1 + \varepsilon_I\right)^2 - \varepsilon_D^2 - \varepsilon_T^2} \qquad (16)$$

$$V_{Offset} \approx \frac{1}{\Gamma_1} \frac{\rho_0(T)}{d} I[\cos(2\theta)\varepsilon_D + \sin(2\theta)\varepsilon_T] \qquad (17)$$

$$\Delta V_W \approx \frac{1}{\Gamma_2} \frac{\rho_0(T)}{d} I[-\sin(2\theta)\varepsilon_D + \cos(2\theta)\varepsilon_T] \qquad (18)$$

Der Winkel $\theta$ bezeichnet den Winkel, den die Kanten des Hallelementes 1 und die (durch gerade Linien angedeuteten) Kanten des Halbleiterchips einschliessen, wie dies in der Fig. 3 illustriert ist. $\Gamma_1$ und $\Gamma_2$ sind Koeffizienten, die von der Geometrie der Wanne 8 und der Lage und Grösse der Kontakte 9 des Hallelementes 1 abhängen.

Wenn man die Schichtwiderstandsspannung $V_{sq}$, die Offsetspannung $V_{Offset}$ und die differenzielle Widerstandsspannung $\Delta V_W$ miteinander verknüpft gemäss

$$V_S = \sqrt{V_{sq}^2 + \Gamma_1^2 V_{Offset}^2 + \Gamma_2^2 (\Delta V_W)^2} \qquad (19)$$

ergibt sich aus den Gleichungen (14) bis (16), dass die Stressspannung $V_s$ folgender Gleichung genügt

$$V_S \approx \frac{\rho_0(T)}{d} I(1 + \varepsilon_I) \qquad (20)$$

und somit ausschliesslich vom isotropen Stress $\sigma_{iso}$ abhängt. Die Stressspannung $V_s$ ist somit eine direkt aus Messungen bestimmbare Grösse für den isotropen Stress $\sigma_{iso}$. Die Werte für $\Gamma_1$ und $\Gamma_2$ sind derart einzustellen, dass der Einfluss von differenziellem Stress bzw. Shear Stress auf die Stressspannung $V_s$ verschwindet. Sie können beispielsweise mittels Finiter Elemente Simulation oder experimentell ermittelt werden. Die Werte für $\Gamma_1$ und $\Gamma_2$ betragen im Fall eines quadratischen Hallelementes 1 mit in den Ecken angeordneten Kontakten 9 etwa

$$\Gamma_1 = 0.82 \qquad (21)$$

$$\Gamma_2 = 0.6 \qquad (22)$$

Eine bevorzugte Ausführung des Hallsensors ist folgende:

- Als Grundmaterial wird ein Wafer aus (100) Silizium mit <110> Flat verwendet.
- Die Kanten der Halbleiterchips sind parallel bzw. orthogonal zum Flat ausgerichtet.
- Die Kanten des Hallelementes 1 verlaufen parallel zu den Kanten des Halbleiterchips, d.h. es ist der Winkel $\theta = 0$.

In diesem Fall gilt

$$V_{Offset} \approx \frac{1}{\Gamma_1} \frac{\rho_0(T)}{d} \frac{\pi_{44}}{2} (\sigma_{xx} - \sigma_{yy}) I \qquad (23)$$

und

$$\Delta V_W \approx \frac{1}{\Gamma_2} \frac{\rho_0(T)}{d} (\pi_{11} - \pi_{12}) \sigma_{xy} I \qquad (24)$$

Wenn der differenzielle Stress $\sigma_{xx} - \sigma_{yy}$ und der Shear Stress $\sigma_{xy}$ vernachlässigbar klein sind, dann gilt $V_{Offset} \cong 0$ und $\Delta V_W \cong 0$, und die Gleichung (21) vereinfacht sich zu

$$V_S = V_{sq} \tag{25}$$

und mit Gleichung (13) ergibt sich, dass die Stressspannung $V_s$ mittels der Messung einer einzigen Van der Pauw Spannung, zum Beispiel der Van der Pauw Spannung $V_{vdP1}$ oder der Van der Pauw Spannung $V_{vdP2}$, oder, bevorzugt, durch Messung und Mittelung beider Van der Pauw Spannungen $V_{vdP1}$ und $V_{vdP2}$ bestimmt werden kann.

Wenn der differenzielle Stress $\sigma_{xx} - \sigma_{yy}$ nicht vernachlässigbar klein, jedoch der shear stress $\sigma_{xy}$ vernachlässigbar klein ist, dann gilt $\Delta V_W \cong 0$ und die Gleichung (19) vereinfacht sich auf

$$V_S = \sqrt{V_{sq}^2 + \Gamma_1^2 V_{Offset}^2} \tag{26}$$

Wenn der differenzielle Stress $\sigma_{xx} - \sigma_{yy}$ vernachlässigbar klein, der shear stress $\sigma_{xy}$ jedoch nicht vernachlässigbar klein ist, dann gilt $V_{Offset} \cong 0$ und die Gleichung (19) vereinfacht sich auf

$$V_S = \sqrt{V_{sq}^2 + \Gamma_2^2 (\Delta V_W)^2} \tag{27}$$

Die Widerstandsmessungen in den Schaltpositionen 5 und 6 sind somit nur dann erforderlich, wenn der shear stress $\sigma_{xy}$ nicht vernachlässigbar klein ist.

C) Bestimmung eines relativen Stresswertes

Der Stresswert bzw. die Stressspannung $V_s$ hängt sowohl vom isotropen Stress $\sigma_{iso}$ als auch von der Temperatur $T$ ab. Um einen von der Temperatur $T$ unabhängigen Stresswert zu erhalten wird deshalb ein relativer Stresswert $V_{Sre1}$ gebildet. Der relative Stresswert $V_{Sre1}$ ist beispielsweise das Verhältnis der Stressspannung $V_s$ in Bezug auf eine von der Temperatur $T$ abhängige Referenzfunktion $V_{S,ref}(T)$

$$V_{Srel} = \frac{V_S}{V_{S,ref}(T)} \tag{28}$$

Die Referenzfunktion $V_{S,ref}(T)$ wird mittels eines Kalibriervorgangs ermittelt. Die Kalibration erfolgt wie im Abschnitt "IV. Erfassung der Kalibrierdaten" beschrieben.

Falls der Stresssensor bei einer festen Temperatur $T_r$ oder in einem relativ kleinen Temperaturbereich eingesetzt wird, dann kann die Referenzfunktion $V_{S,ref}(T)$ durch einen festen Referenzwert ersetzt werden.

Weil es im Wesentlichen der isotrope Stress $\sigma_{iso}$ ist, der den Piezo-Halleffekt bewirkt, eignet sich die Stressspannung $V_s$ bei einem Hallelement für die Kompensation des Piezo-Halleffektes. Das Hallelement 1 dient dann sowohl für die Messung des isotropen Stresses als auch für die Messung der Komponente des Magnetfeldes, die senkrecht zu seiner aktiven Oberfläche verläuft. Dies wird nachfolgend erläutert.

III. Modellierung der Stress- und Temperaturkompensation des Hallelementes

Das Ausgangssignal $D_{Out}$ des Hallsensors soll unabhängig von der Temperatur und vom Stress sein, der im folgenden allgemein als Stress $\sigma$ bezeichnet wird. Der Hall-Spannungswert $V_{Hall}$ wird mit einem Korrekturfaktor multipliziert, um das Temperatur- und stresskompensierte Ausgangssignal $D_{Out}$ zu erhalten. Das Ausgangssignal $D_{Out}$ wird erfindungsgemäss modelliert durch die Beziehung

$$D_{Out} = \frac{V_{Hall}}{V_{Hall,ref}(T)} h\left(V_S / V_{S,ref}(T), \gamma(T)\right) B_{ref} \tag{29}$$

wobei die Funktion h vom relativen Stresswert $V_{Sre1}$, d.h. vom Verhältnis $V_s/V_{S,ref}(T)$ abhängt und beispielsweise folgende Funktion ist

$$h\left(V_S / V_{S,ref}(T), \gamma(T)\right) = \frac{1}{1 - \gamma(T)\left(\dfrac{V_S}{V_{S,ref}(T)} - 1\right)} \tag{30}$$

$V_{Hall}$ ist ein durch die Messungen erhaltener Hall-Spannungwert, der gegeben ist durch:

$$V_{Hall} = \tfrac{1}{2} * (V_{diag1} + V_{diag2}) \tag{31}$$

$V_s$ ist die durch die Messungen ermittelte Stressspannung. $V_{Hall,ref}(T)$ und $V_{S,ref}(T)$ sind Referenzfunktionen, die für den Fall, dass ein Referenzmagnetfeld der Stärke $B_{ref}$ am Hallelement anliegt, mittels einer Kalibrierung ermittelt und im Mikrocontroller 6 des Hallsensors gespeichert werden. $\gamma(T)$ ist eine von den Materialeigenschaften der Wanne 8 des Hallelementes 1 abhängige Referenzfunktion, die in guter Näherung approximiert werden kann durch

$$\gamma(T) \approx -\frac{2P_{12}(T)}{\Pi_{11}(T) + \Pi_{12}(T)} \tag{32}$$

Aus Literaturwerten, insbesondere aus den Arbeiten von B. Hälg (Piezo-Hall coefficients of n-type silicon, J. Appl. Physics 64 (1), 1 July 1988), von Y. Kanda (A Graphical Representation of Piezoresistance Coefficients in Silicon, IEEE Transactions on electron devices, Vol.. ED-29, No. 1, January 1982) und von Ch. Smith (Piezoresistance Effect in Germanium and Silicon, Physical Review, Vol. 94, Number 1, April 1, 1954), ergibt sich der Wert der Funktion $\gamma(T = 25\,°C)$ für eine Wanne 8 mit einer niedrigen Dotierung von $N = 3*10^{16}$ etwa zu

$$\gamma(T = 25°\,C) = 2*40\%/GPa / 48\%/GPa = 1.66 \tag{33}$$

Die Temperaturkoeffizienten von $P_{12}$, $\pi_{11}$ und $\pi_{12}$ betragen etwa

$$TC(P_{12}) = -1750\,ppm / °C \tag{34}$$

$$TC(\pi_{11}) = TC(\pi_{12}) = -3350\,ppm / °C \tag{35}$$

Die Referenzfunktion $\gamma(T)$ kann Beispiel als Polynom zweiten Grades dargestellt werden. Für die in den Gleichungen (32) bis (34) angegebenen Werte ergibt sich

$$\gamma(T) = 1.66 + 0.0016 * (T-25°C) + 0.000005 * (T-25°C)^2 \tag{36}$$

Die Gleichung (30) kann als Taylor Reihe entwickelt und dann die Gleichung (29) unter Berücksichtigung einzig des Terms erster Ordnung dargestellt werden als

$$D_{Out} = \frac{V_{Hall}}{V_{Hall,ref}(T)}\left(1 + \gamma(T)\left(\frac{V_S}{V_{S,ref}(T)} - 1\right)\right)B_{ref} \qquad (37)$$

Falls der Hallsensor bei einer festen Temperatur $T_r$ oder in einem relativ kleinen Temperaturbereich eingesetzt wird, dann können die Referenzfunktionen $V_{Hall, ref}(T)$ und $V_{S, ref}(T)$ und die Funktion $\gamma(T)$ durch konstante Referenzwerte ersetzt werden, d.h.

$$V_{Hall, ref}(T) = V_{Hall, ref}(T_r) = V_{Hall, ref}$$

$$V_{S, ref}(T) = V_{S, ref}(T_r) = V_{S, ref}$$

$$\gamma(T) = \gamma$$

wobei die Werte $V_{Hall, ref}(T_r)$ und $V_{s, ref}(T_r)$ gemäss dem nachfolgend beschriebenen Kalibriervorgang einzig für die Temperatur $T_r$ ermittelt werden. In diesem Fall ergibt sich Gleichung (29) zu

$$D_{Out} = \frac{V_{Hall}}{V_{Hall,ref}} h\left(V_S / V_{S,ref}, \gamma\right)B_{ref} \qquad (38)$$

und dann beispielsweise mit Gleichung (30)

$$D_{Out} = \frac{V_{Hall}}{V_{Hall,ref}}\left(\frac{1}{1 - \gamma *\left(\frac{V_S}{V_{S,ref}} - 1\right)}\right)B_{ref} \qquad (39)$$

$$D_{Out} = \frac{V_{Hall}}{V_{Hall,ref}}\left(1 + \gamma *\left(\frac{V_S}{V_{S,ref}} - 1\right)\right)B_{ref} \qquad (40)$$

Das Ausgangssignal $D_{out}$ des Hallsensors ist stresskompensiert.

IV. Erfassung der Kalibrierdaten

Die Kalibration wird erläutert am Beispiel des Hallsensors. Die Kalibration des Stresssensors erfolgt auf analoge Weise, wobei dann allerdings das Anlegen eines Magnetfeldes $B_{ref}$ und die Bestimmung des Hall-Spannungswertes nicht erforderlich sind.
$V_{Hall, ref}(T)$ und $V_{s, ref}(T)$ sind Referenzfunktionen, die von der Temperatur T abhängen. Die Kalibrierung dient dazu, diese Funktionen zu bestimmen, und umfasst folgende Schritte:

-   Bringen des Hallsensors auf verschiedene vorbestimmte Temperaturen $T_i$, wobei der Index i Werte von 1 bis n annimmt und n eine ganze Zahl mit n $\geq$ 1 ist. Es ist beispielsweise n = 3 und $T_1$ = -40° C, $T_2$ = 25° C und $T_3$ = 125° C.
-   Anlegen eines Referenzmagnetfeldes $B_{ref}$

- Messen der aktuellen Ist-Temperatur des Hallelementes $T_{ist}(i)$
- Messen der Diagonalspannungen $V_{diag1, ref}(i)$ und $V_{diag2, ref}(i)$
- Messen mindestens einer und ev. einer zweiten van der Pauw Spannung $V_{vdP1, ref}(i)$, $V_{vdP2, ref}(i)$ und daraus
- mit Gleichung (34) Berechnen des Hall-Spannungswertes $V_{Hall, ref}(i)$, und
- Berechnen der Stressspannung $V_{S, ref}(i)$.

Die Berechnung der Stresswerte $V_{S, ref}(i)$ erfolgt entsprechend der Verwendung des Sensors und/oder der zu erwartenden mechanischen Belastungen auf Basis der Gleichung (22) oder (29) oder (30).

Die Kalibrierdaten bestehen aus den i = 1 bis n Datensätzen $\{T_{ist}(i), V_{Hall, ref}(i), V_{S, ref}(i)\}$. Die beiden Referenzfunktionen $V_{Hall, ref}(T)$ und $V_{S, ref}(T)$ werden bevorzugt als Polynome der Ordnung 2 oder einer höheren Ordnung dargestellt. In diesem Fall werden die Koeffizienten der Polynome mit üblichen statistischen Methoden, z.B. durch einen mathematischen Fit, aus den n Datensätzen $\{T_{ist}(i), V_{Hall, ref}(i)\}$ bzw. $\{T_{ist}(i), V_{S, ref}(i)\}$ bestimmt und im Microkontroller 6 des Hallsensors gespeichert..

Der Wert $B_{ref}$ des Referenzmagnetfeldes und die Referenzfunktion $\gamma(T)$ werden ebenfalls im Microkontroller 6 des Hallsensors gespeichert. Die Kalibrierung ist damit abgeschlossen. Die Referenzfunktion $V_{Hall, ref}(T)$ steht in Bezug zum Referenzmagnetfeld $B_{ref}$, d.h. $V_{Hall, ref}(T)$ ist proportional zu $B_{ref}$.

Die Kalibrierung kann beispielsweise an dem in ein Gehäuse verpackten Hallsensor durchgeführt werden. Sie kann aber auch durchgeführt werden, wenn der Wafer mit den Hallsensoren noch nicht zersägt worden ist, oder sie kann an den Hallsensoren durchgeführt werden, bevor sie in ein Gehäuse eingegossen werden.

Wenn für ein bestimmtes Endprodukt ausreichend Kalibrierungsdaten gesammelt worden sind, dann kann es sein, dass die Kalibrierung auf andere Weise erfolgen kann.

Um die Genauigkeit zu erhöhen, kann die Referenzfunktion $\gamma(T)$ auch experimentell bestimmt werden. Dies erfolgt, indem die Kalibration für zwei verschiedene Stressbedingungen durchgeführt wird. Es werden dann für verschiedene Temperaturen i = 1 bis n erste Datensätze $\{T_{ist}(i), V_{Hall, ref}(i), V_{S, ref}(i)\}$ für die Stressbedingung 1 und k = 1 bis h zweite Datensätze $\{T_{ist}(k), V_{Hall, sec}(k), V_{S, sec}(k)\}$ für die Stressbedingung 2 durchgeführt. Bei der Stressbedingung 1 wird das Magnetfeld $B_{ref}$ angelegt, bei der Stressbedingung 2 wird das Magnetfeld $B_{sec}$ angelegt. $B_{sec}$ kann gleich $B_{ref}$ sein. Beispielsweise ist n = 3 und h = 3. Wenn die Daten als Kalibrierfunktionen $V_{Hall, ref}(T)$, $V_{S, ref}(T)$, $V_{Hall, sec}(T)$ und $V_{s, sec}(T)$ dargestellt werden, kann die Referenzfunktion $\gamma(T)$ wie folgt bestimmt werden:

$$\gamma(T) = \frac{\dfrac{V_{Hall,sec}(T)}{V_{Hall,ref}(T)}\dfrac{B_{ref}}{B_{sec}} - 1}{1 - \dfrac{V_{S,sec}(T)}{V_{S,ref}(T)}} \qquad (41)$$

Die folgende Tabelle gibt einen Überblick über mögliche Kalibrierungsmessungen mit unterschiedlichen Stressbedingungen:

| Möglichkeit Nr. | Stressbedingung 1 für $V_{Hall, ref}(T)$, $V_{S, ref}(T)$ | Stressbedingung 2 für $V_{Hall, sec}(T)$ und $V_{S, sec}(T)$ |
|---|---|---|
| 1 | Sensor unzersägt auf Wafer (Wafer-level) | Sensor verpackt |
| 2 | Sensor verpackt | Sensor unzersägt auf Wafer (Wafer-level) |
| 3 | Sensor verpackt und Sensorgehäuse trocken | Sensor verpackt und Sensorgehäuse feucht |
| 4 | Sensor verpackt | Äussere Kraft auf das Sensorgehäuse |

Das erfindungsgemässe Verfahren ist nicht auf Hallelemente mit vier Kontakten beschränkt, sondern lässt sich ohne weiteres auf Hallelemente mit k*4 Kontakten übertragen, wobei k eine ganze Zahl ist.

Die Erfindung wurde erläutert am Beispiel, dass die Korrektur, die die durch den mechanischen Stress und die Temperatur bewirkte Änderung des Hall-Spannungswertes des Hallelementes 1 kompensieren soll, auf rechnerische Weise im Microkontroller 6 durchgeführt wird. Es ist aber auch möglich, die Kompensation des Einflusses der Temperatur und/oder des mechanischen Stresses durch eine Änderung des Hallstromes vorzunehmen.

**Patentansprüche**

1. Verfahren für die Bestimmung eines Stresswertes $V_s$ für isotropen Stress, mittels eines Hallelementes (1), das ein plattenförmiges Gebiet aus einem dotierten Halbleitermaterial aufweist und vier Kontakte (9) umfasst, die das Gebiet kontaktieren und winkelmässig gleichmässig um jeweils 90° versetzt sind, **gekennzeichnet durch folgende Schritte:**

   Messen mindestens eines Van der Pauw Wertes in mindestens einem Van der Pauw Mess-Setup des Hallelementes (1),
   aus dem mindestens einen Van der Pauw Wert Berechnen einer Schichtwiderstandsgrösse, und
   Berechnen des Stresswertes $V_s$, der wenigstens von der Schichtwiderstandgrösse abhängt.

2. Verfahren nach Anspruch 1, **dadurch gekennzeichnet, dass** der Schritt des Messens mindestens eines Van der Pauw Wertes beinhaltet
   entweder Messen eines ersten Van der Pauw Wertes in einem ersten Van der Pauw Mess-Setup des Hallelementes und Messen eines zweiten Van der Pauw Wertes in einem zweiten Van der Pauw Mess-Setup, oder
   Messen eines ersten Van der Pauw Wertes in einem ersten Van der Pauw Mess-Setup,
   Messen einer ersten Diagonalspannung in einem ersten Diagonal Mess-Setup,
   Messen einer zweiten Diagonalspannung in einem zweiten Diagonal Mess-Setup, und
   Berechnen eines zweiten Van der Pauw Wertes aus dem ersten Van der Pauw Wert und der Differenz der beiden Diagonalspannungen.

3. Verfahren nach Anspruch 1 oder 2, **dadurch gekennzeichnet, dass** der Schritt des Berechnens des Stresswertes $V_s$ heisst Setzen des Stresswertes $V_s$ proportional zur Schichtwiderstandsgrösse.

4. Verfahren nach einem der Ansprüche 1 bis 3, **dadurch gekennzeichnet, dass** der Schritt des Berechnens einer Schichtwiderstandsgrösse aus dem mindestens einen Van der Pauw Wert heisst Setzen der Schichtwiderstandsgrösse proportional zu dem mindestens einen van der Pauw Wert oder proportional zum Mittelwert des ersten und zweiten van der Pauw Wertes.

5. Verfahren nach einem der Ansprüche 1 bis 4, **dadurch gekennzeichnet, dass** ein relativer Stresswert $V_{Sre1}$ gebildet wird zu

$$V_{Srel} = \frac{V_S}{V_{S,ref}(T)}$$

   wobei $V_{S,ref}(T)$ eine von der Temperatur T abhängige Referenzfunktion ist.

6. Verfahren für die Bestimmung einer Komponente eines Magnetfeldes, **gekennzeichnet durch folgende Schritte:**

   Bestimmen des Stresswertes $V_s$ nach einem der Ansprüche 2 bis 4,
   Berechnen eines Hall-Spannungwertes $V_{Hall}$ **durch** Addieren der ersten Diagonalspannung und der zweiten Diagonalspannung,
   Berechnen der Komponente des Magnetfeldes aus dem Hall-Spannungwert $V_{Hall}$, dem Stresswert $V_s$, einem Referenz-Hall-Spannungswert $V_{Hall,ref}$ und einem Referenzstresswert $V_{S,ref}$.

7. Verfahren für die Bestimmung einer Komponente eines Magnetfeldes, **gekennzeichnet durch folgende Schritte:**

   Bestimmen des Stresswertes $V_s$ nach einem der Ansprüche 2 bis 4,
   Messen einer Temperatur $T_a$ des Hallelementes,
   Berechnen eines Hall-Spannungwertes $V_{Hall}$ **durch** Addieren der ersten Diagonalspannung und der zweiten Diagonalspannung,
   Berechnen der Werte W von Referenzfunktionen, die sie bei der Temperatur $T_a$ des Hallelementes haben, und
   Berechnen der Komponente des Magnetfeldes aus dem Hall-Spannungwert $V_{Hall}$, dem Stresswert $V_s$ und den Werten W.

8. Verfahren nach Anspruch 7, **dadurch gekennzeichnet, dass** die Referenzfunktionen drei Funktionen $V_{Hall, ref}(T)$, $V_{S,ref}(T)$ und $\gamma(T)$ umfassen, wobei der Parameter T die Temperatur bezeichnet und wobei $h(V_s/V_{S,ref}(T), \gamma(T))$ eine Funktion bezeichnet, die vom Stresswert $V_s$ und dem Verhältnis $V_s/V_{S,ref}(T)$ und der Referenzfunktion $\gamma(T)$ abhängt, und dass ein Wert $D_{Out}$ für die Komponente des Magnetfeldes berechnet wird gemäss der Gleichung

$$D_{Out} = \frac{V_{Hall}}{V_{Hall,ref}(T_a)} h\left(V_S / V_{S,ref}(T_a), \gamma(T_a)\right) B_{ref}$$

oder einer davon abgeleiteten Gleichung, wobei $B_{ref}$ ein Referenzmagnetfeld ist, auf das sich die Funktion $V_{Hall, ref}(T)$ bezieht, wobei bevorzugt

$$h\left(V_S / V_{S,ref}(T), \gamma(T)\right) = \frac{1}{1 - \gamma(T)\left(\dfrac{V_S}{V_{S,ref}(T)} - 1\right)}$$

9. Verfahren nach Anspruch 8, **dadurch gekennzeichnet, dass** die Referenzfunktionen $V_{Hall, ref}(T)$ und $V_{S, ref}(T)$ mittels einer Kalibrierung ermittelt werden, die wenigstens folgende Schritte umfasst:

Anlegen des Referenzmagnetfeldes $B_{ref}$,
Bringen des Hallsensors auf verschiedene vorbestimmte Temperaturen $T_i$, wobei der Index i Werte von 1 bis n annimmt und n eine ganze Zahl mit $n \geq 1$ ist,
Für jede Temperatur $T_i$:

Messen der Temperatur des Hallelementes $T_{ist}(i)$,
Messen der ersten und zweiten Diagonalspannung in den beiden Diagonal Mess-Setups des Hallelementes und Berechnen eines Hall-Spannungswertes $V_{Hall, ref}(i)$;
Messen mindestens eines Van der Pauw Wertes $V_{vdP}(i)$ in mindestens einem Van der Pauw Mess-Setup des Hallelementes;
Berechnen einer Stressspannung $V_{S, ref}(i)$;

und dann
Bestimmen der Referenzfunktion $V_{Hall, ref}(T)$ aus den Datensätzen $\{T_{ist}(i), V_{Hall, ref}(i)\}$; und
Bestimmen der Referenzfunktion $V_{S, ref}(T)$ aus den Datensätzen $\{T_{ist}(i), V_{S, ref}(i)\}$.

10. Verfahren nach Anspruch 9, **dadurch gekennzeichnet, dass** für verschiedene Temperaturen $T_i$ mit i = 1 bis n erste Datensätze $\{T_{ist}(i), V_{Hall, ref}(i), V_{S, ref}(i)\}$ für eine erste Stressbedingung des Hallsensors und für verschiedene Temperaturen $T_k$ mit k = 1 bis h zweite Datensätze $\{T_{ist}(k), V_{Hall, sec}(k), V_{S, sec}(k)\}$ für eine zweite Stressbedingung des Hallsensors ermittelt werden, wobei n und h ganze Zahlen mit $n \geq 1$ und $h \geq 1$ sind, dass aus den ersten Datensätzen Referenzfunktionen $V_{Hall, ref}(T)$ und $V_{S, ref}(T)$ und aus den zweiten Datensätzen Referenzfunktionen $V_{Hall, sec}(T)$ und $V_{S, sec}(T)$ ermittelt werden, und dass die Referenzfunktion $\gamma(T)$ bestimmt wird als

$$\gamma(T) = \frac{\dfrac{V_{Hall,sec}(T)}{V_{Hall,ref}(T)} \dfrac{B_{ref}}{B_{sec}} - 1}{1 - \dfrac{V_{S,sec}(T)}{V_{S,ref}(T)}}$$

wobei die Grösse $B_{ref}$ das bei der Ermittlung der ersten Datensätze angelegte Magnetfeld und die Grösse $B_{sec}$ ein bei der Ermittlung der zweiten Datensätze angelegtes Magnetfeld bezeichnet.

11. Stresssensor für die Messung von isotropem Stress, umfassend ein Hallelement (1), eine Schaltmatrix (2), eine Stromquelle (3), einen Differenzverstärker (4), einen Analog-Digital Wandler (5), einen Microkontroller (6) und einen Temperatursensor (7), wobei die Schaltmatrix (2) eingerichtet ist, das Hallelement (1) in mindestens einem van der Pauw Mess-Setup und in zwei Widerstands Mess-Setups zu betreiben und wobei der Microkontroller (6) eingerichtet ist, aus Messwerten der verschiedenen Mess-Setups einen Stresswert für isotropen Stress zu bilden.

**12.** Hallsensor für die Messung einer Komponente eines Magnetfeldes, umfassend ein Hallelement (1), eine Schaltmatrix (2), eine Stromquelle (3), einen Differenzverstärker (4), einen Analog-Digital Wandler (5), einen Microkontroller (6) und einen Temperatursensor (7), wobei die Schaltmatrix (2) eingerichtet ist, das Hallelement (1) in zwei orthogonalen Diagonal Mess-Setups, in mindestens einem van der Pauw Mess-Setup und in zwei Widerstands Mess-Setups zu betreiben und wobei der Microkontroller (6) eingerichtet ist, aus Messwerten der verschiedenen Mess-Setups ein stress- und temperaturkompensiertes Ausgangssignal für die Komponente des Magnetfeldes zu bilden.

Fig. 1

Fig. 2A

Fig. 2B

Fig. 2C

Fig. 2D

Fig. 2E

9.1

9.2

1

+

−

9.4

9.3

Fig. 2F

9.1

1

9.2

+

−

9.4

9.3

Fig. 3

y

1

θ

x

Europäisches
Patentamt

European
Patent Office

Office européen
des brevets

## EUROPÄISCHER RECHERCHENBERICHT

Nummer der Anmeldung

EP 12 16 7042

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2005 029464 A1 (INFINEON TECHNOLOGIES AG [DE]) 28. Dezember 2006 (2006-12-28) | 1,2 | INV. G01L1/18 G01R33/09 |
| Y | * das ganze Dokument * ----- | 3,4 | |
| X | EP 1 496 344 A2 (AUSTRIAMICROSYSTEMS AG [AT]) 12. Januar 2005 (2005-01-12) | 1,2 | |
| Y | * das ganze Dokument * ----- | 3,4 | |
| X | JESSE LAW ET AL: "A High Sensitivity MEMS Pressure Sensor", MICROELECTRONICS AND ELECTRON DEVICES, 2007 IEEE WORKSHOP ON, IEEE, PI, 1. April 2007 (2007-04-01), Seiten 51-52, XP031095128, ISBN: 978-1-4244-1113-9 | 1,2 | |
| Y | * das ganze Dokument * ----- | 3,4 | |
| X | AHSAN MIAN, JEFFREY C. SUHLING, RICHARD JAEGER: "The van der Pauw Stress sensor", IEEE SENSORS JOURNAL, [Online] Bd. 6, Nr. 2, 1. April 2006 (2006-04-01), Seiten 340-356, XP002684798, * das ganze Dokument * ----- | 1,2 | |

RECHERCHIERTE SACHGEBIETE (IPC)

G01L
G01R

Der vorliegende Recherchenbericht wurde für alle Patentansprüche erstellt

| Recherchenort | Abschlußdatum der Recherche | Prüfer |
|---|---|---|
| Den Haag | 8. Oktober 2012 | Stavroulis, Stefanos |

EPO FORM 1503 03.82 (P04C03)

**EP 2 662 675 A1**

**ANHANG ZUM EUROPÄISCHEN RECHERCHENBERICHT**
**ÜBER DIE EUROPÄISCHE PATENTANMELDUNG NR.**                    EP 12 16 7042

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-10-2012

| Im Recherchenbericht angeführtes Patentdokument | Datum der Veröffentlichung | Mitglied(er) der Patentfamilie | Datum der Veröffentlichung |
|---|---|---|---|
| DE 102005029464 A1 | 28-12-2006 | DE 102005029464 A1<br>US 2007018655 A1 | 28-12-2006<br>25-01-2007 |
| EP 1496344 A2 | 12-01-2005 | DE 10331096 A1<br>EP 1496344 A2 | 10-02-2005<br>12-01-2005 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0118556 A
- EP 548391 A
- DE 4302342
- DE 10154495
- DE 10154498
- DE 102004003853
- DE 102008051949

**In der Beschreibung aufgeführte Nicht-Patentliteratur**

- **B. HÄLG.** Piezo-Hall coefficients of n-type silicon. *J. Appl. Physics,* 01. Juli 1988, vol. 64 (1
- **Y. KANDA.** A Graphical Representation of Piezoresistance Coefficients in Silicon. *IEEE Transactions on electron devices,* Januar 1982, vol. ED-29 (1
- **CH. SMITH.** Piezoresistance Effect in Germanium and Silicon. *Physical Review,* 01. April 1954, vol. 94 (1